# EUROPEAN PATENT APPLICATION

(11) **EP 4 661 076 A1**
(43) Date of publication of application: **10.12.2025**
(21) Application number: 25174406.6
(22) Date of filing: 06.05.2025
(51) Int. Cl.: H01L 23/053, H01L 23/24, H01L 23/373, H01L 23/498, H01L 23/62, H01L 25/07

(54) **LOW PROFILE POWER MODULE**

(30) Priority: 07.06.2024 US 202418737289
(71) Applicant: Infineon Technologies AG, 85579 Neubiberg (DE)
(72) Inventor: LUDWIG, Marco, 58739 Wickede/ Ruhr (DE); NOTTELMANN, Regina, 59510 Lippetal (DE); SCHMER, Alexander, 59494 Soest (DE); ACUNA, Javier, 59494 Soest (DE); TIESSEN, Natalia, 59558 Lippstadt (DE)
(74) Representative: Westphal, Mussgnug & Partner, Patentanwälte mbB

(57) **Abstract**

A power module includes a substrate, a plurality of power semiconductor dies, an electrically insulative enclosure, and an electrical interface for the power semiconductor dies. The substrate includes a first metallized side and a second metallized side separated from one another by an electrically insulative body. The plurality of power semiconductor dies is attached to the first metallized side of the substrate. The electrical interface is accessible outside of the electrically insulative enclosure. An electrically insulative coating is applied to at least part of the first metallized side of the substrate, at least part of the power semiconductor dies, and at least part of the electrical interface. A combined height of the lidless electrically insulative enclosure and the substrate is 6mm or less. The power module may also include a lid or may be lidless.

## Description

### BACKGROUND

Demand for electronic modules for power applications, commonly referred to as power modules, continues to increase rapidly across a wide range of industries, including automotive, consumer electronics, renewable energy, manufacturing, and medical, among many others. Developments in semiconductor materials such as silicon carbide (SiC), silicon (Si), and gallium nitride (GaN) have enabled such power modules to be manufactured with advantageous features such as smaller footprint, higher voltage and current capabilities, and faster switching speeds.

Some applications for power modules, such as power converters, may utilize baseplateless power modules. A baseplateless power module typically includes one or more power semiconductor dies that are attached to a substrate and are enclosed in an electrically insulative enclosure (e.g., a molded frame). The module is 'baseplateless' in that the substrate is designed for mounting to a heatsink without the use of an intervening baseplate. An externally accessible electrical interface to the power semiconductor dies enables the customer or end user to integrate the baseplateless power module into a desired application. Standard applications are designed to accommodate the baseplateless power module in a space, for example between a heatsink and a printed circuit board (PCB), having a height of about 12mm, and thus the package heights of power modules for these applications are designed accordingly. However, some applications, such as integrated converters for electric vehicles (EVs), require a power module having a thinner form factor that is less than 12mm, e.g., a package height of about 6mm or less. In such applications, reducing the height of the package to meet such spatial requirements may compromise the ability to meet other design requirements of the power module.

One such requirement is creepage distance, which is the minimum distance between terminals along the surface of an insulation material. Some creepage pathways may exist along surfaces of the power module package, such as along the electrically insulative enclosure between a conductor of the electrical interface and a package fastener (e.g., for attachment to a heatsink). For such creepage pathways, decreasing the package height may be accompanied by a decrease in creepage distance. Increasing the package size to compensate for this decrease in creepage distance may be an acceptable solution for some applications but may exceed dimensional constraints for others. Additionally, or alternatively, using a housing material having a high comparative tracking index (CTI) may decrease the required creepage distance between terminals, however such materials are often expensive.

Another design consideration of power modules is the electrical isolation of the substrate metallization and the semiconductor dies. Typically, the enclosure of the power module is partly filled with an electrically insulative coating of a potting compound, for example a gel compound, or other insulating material that covers the semiconductor dies and metallized surfaces of the substrate. Sufficient electrical isolation requires this electrically insulative coating to have a minimum thickness. Additionally, these materials typically expand as the semiconductor dies heat during operation of the power module, and thus there must be sufficient volume in the enclosure above the electrically insulative coating to accommodate this expansion. The ability to reduce the height of the power module package to conform to the spatial requirements of some applications may be constrained by the required thickness of the electrically insulative coating and/or the required volume in the enclosure that is available to accommodate expansion of the electrically insulative coating.

For some applications that require thin power modules, discrete modules may be suitable. However, integrating these into an application may introduce other complexities in assembly as well as differences related to electrical and/or thermal performance.

Thus, there is a need for a solution that enables a baseplateless power module having a thin form factor (e.g., a package height less than 12mm) without compromising other design requirements such as creepage distance and electrical isolation of the semiconductor dies and substrate.

### SUMMARY

According to an embodiment of a power module, the power module comprises: a substrate comprising a first metallized side and a second metallized side separated from one another by an electrically insulative body; a plurality of power semiconductor dies attached to the first metallized side of the substrate; a lidless electrically insulative enclosure, the lidless electrically insulative enclosure and the substrate defining an open cavity which laterally encloses the power semiconductor dies; an electrical interface for the power semiconductor dies that is accessible via the open cavity; and an electrically insulative coating applied to at least part of the first metallized side of the substrate, at least part of the power semiconductor dies, and at least part of the electrical interface, wherein a combined height of the lidless electrically insulative enclosure and the substrate is 6mm or less.

According to another embodiment of a power module, the power module comprises: a substrate comprising a first metallized side and a second metallized side separated from one another by an electrically insulative body; a plurality of power semiconductor dies attached to the first metallized side of the substrate; an electrically insulative enclosure laterally enclosing the power semiconductor dies; an electrical interface for the power semiconductor dies; and a first metallic fastener jutting out from a first exterior side face of the electrically insulative enclosure, wherein a creepage distance between the first metallic fastener and a neighboring conductor of the electrical interface includes the first exterior side face of the electrically insulative enclosure, a first interior side face of the electrically insulative enclosure that opposes the first exterior side face, and a surface of the electrically insulative enclosure that extends between the first exterior side face and the first interior side face, wherein a combined height of the electrically insulative enclosure and the substrate is 6mm or less.

Those skilled in the art will recognize additional features and advantages upon reading the following detailed description, and upon viewing the accompanying drawings.

### BRIEF DESCRIPTION OF THE FIGURES

The elements of the drawings are not necessarily to scale relative to each other. Like reference numerals designate corresponding similar parts. The features of the various illustrated embodiments can be combined unless they exclude each other. Embodiments are depicted in the drawings and are detailed in the description which follows.
FIG. 1 illustrates a perspective view of a power module, according to an embodiment.
FIG. 2 illustrates a side cross-sectional view of a power module, according to an embodiment.
FIGS. 3A-3D illustrate partial side cross-sectional views of a power module, according to embodiments.
FIG. 4 illustrates a perspective view of a power module, according to an embodiment.
FIG. 5 illustrates a side cross-sectional view of a power module, according to an embodiment.
FIGS. 6A-6D illustrate partial side cross-sectional views of a power module, according to embodiments.

### DETAILED DESCRIPTION

Described herein is a low profile baseplateless power module having a thin form factor, for example a package height less than 12mm. In some embodiments, the power module described herein has a package height that is 6mm or less. The power module includes one or more features that enable the power module to conform to specific design requirements despite having a thinner package.

In some embodiments, the low profile power module includes a lidless electrically insulative enclosure. Utilizing a lidless enclosure may, in some instances, provide additional room for thermal expansion of the electrically insulative coating. This additional room may at least partly compensate for the decrease in room for thermal expansion of the electrically insulative coating due to the thinner package. Additionally, as will be illustrated, utilizing a lidless enclosure may increase the creepage distance along a package surface between a fastener of the power module and a neighboring conductor of the electrical interface by effectively lengthening the associated creepage pathway to further extend along an interior side face of the lidless electrically insulative enclosure. Alternatively, in some embodiments, the electrically insulative enclosure includes a lid but is structured to include a gap between the lid and the interior side face of the electrically insulative enclosure, effectively achieving a lengthening of the creepage pathway along the interior side face of the enclosure in a manner similar to that of the lidless enclosure. In some examples, utilizing the interior side face to lengthen a creepage pathway, either using a lidless enclosure or an enclosure having a gap between the lid and the interior side face, may enable the thinner power module described herein to meet the required creepage distance for a given voltage class without the need to increase the size of the enclosure in other dimensions, thus preserving the footprint of the power module.

In some embodiments, the electrically insulative coating that covers the power semiconductor dies and the metallization of the substrate has a thickness that is less than that of a standard power module. For example, the electrically insulative coating may have a thickness of 2mm or less. A thinner coating reduces the room required to accommodate the thermal expansion of the electrically insulative coating both due to the reduced thickness of the layer and the reduced volume of material in the layer and may thus be suitable for thinner power module described herein. Additionally, when used in combination with a lidless electrically insulative enclosure or an electrically insulative enclosure having a gap between the lid and the interior side face, a thinner electrically insulative coating may lengthen the portion of the creepage pathway that extends along the interior side face. However, as noted above, a minimum thickness of the electrically insulative coating may be required to ensure sufficient isolation of the power semiconductor dies and the metallization of the substrate. In some examples described here, the electrically insulative coating includes a jetted compound, that is, a compound that is applied using a jetting process. Such a process may promote more conformal coverage of the power semiconductor dies and the metallization and may thus enable a thinner coating to be used to achieve sufficient isolation. In some other examples described herein, the electrically insulative coating comprises a potting compound comprising liquid or viscous material poured into the enclosure and then cured to form a solid or gel layer.

In some embodiments, the electrically insulative enclosure is formed with features such as protruding ridges that extend along at least a part of an outer perimeter and/or inner perimeter of the electrically insulative enclosure. Such features may increase the creepage distance of creepage pathways that extend along the power module package, for example between a fastener of the power module and a neighboring conductor of the electrical interface.

Described next, with reference to the figures, are exemplary embodiments of the power module.

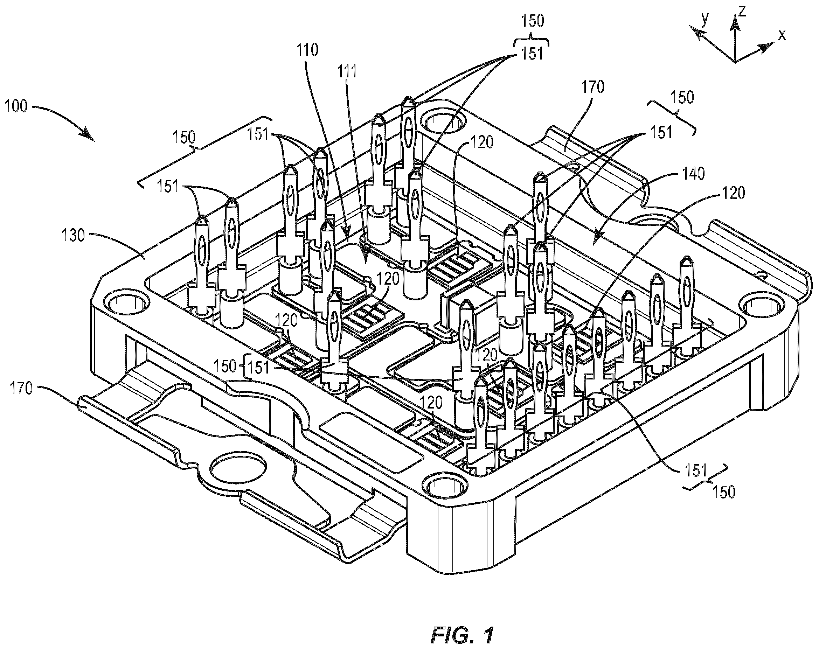

FIG. 1 illustrates a perspective view of a low profile power module 100, according to an embodiment. The power module includes a substrate 110 and a plurality of power semiconductor dies 120. The power semiconductor dies 120 are attached to a first metallized side 111 of the substrate 110. The power module 100 includes an electrical interface 150 for the power semiconductor dies 120.

Examples of the substrate 110 include a DCB (direct copper bonded) or AMB (active metal brazed) substrate, printed circuit board (PCB), lead frame, or other substrate, e.g., insulated metal substrate (IMS), etc. The first metallized side 111 may include layers such as contact pads and/or traces that are electrically coupled to the power semiconductor dies 120. The first metallized side 111 may include copper, aluminum, an alloy, etc.

The power semiconductor dies 120 may each include one or more devices, including transistors, diodes, resistors, capacitors, and/or other types of active or passive devices. One or more of the power semiconductor dies 120 may be a vertical power semiconductor die (e.g., a vertical power transistor die). For a vertical power transistor die, the primary current flow path is between the front and back sides of the power semiconductor die 120 (along the z direction in FIG. 1). In one embodiment, one or more power semiconductor dies 120 are SiC transistor dies such as SiC power MOSFET (metal-oxide-semiconductor field-effect transistor) dies. One or more of the power semiconductor dies 120 may be a HEMT (high-electron mobility transistor) die, IGBT (insulated-gate bipolar transistor) die, JFET (junction filed-effect transistor) die, Si power MOSFET die, etc. The power semiconductor dies 120 attached to the substrate 110 may all be of a similar or identical design (e.g., device type, structure, materials, dimensions, etc.), or some or each of the power semiconductor dies 120 may have different designs. Various arrangements of designs of power semiconductor dies 120 on the substrate 110 are contemplated. The power semiconductor dies 120 and/or their constituent devices may be arranged to form all or part of a power electronics circuit such as a DC/AC inverter, a DC/DC converter, an AC/DC converter, a DC/AC converter, an AC/AC converter, a multi-phase inverter, an H-bridge, motor driver, etc. In some examples, a power electronics circuit that includes the power semiconductor dies 120 is a half-bridge or full-bridge circuit.

The electrical interface 150 includes a plurality of conductors 151. In the example of the power module 100 of FIG. 1, each conductor 151 includes a pin. For this and similar examples described herein, the terms conductor/conductors 151 and pin/pins 151 may be used interchangeably. Each pin 151 is configured to interface with a component (e.g., a PCB) of the application into which the power module 100 will be integrated.

According to an embodiment, the power module 100 of the example of FIG. 1 includes a lidless electrically insulative enclosure 130. The electrically insulative enclosure 130 is lidless in that the enclosure 130 and the substrate 110 define an open cavity 140 which laterally encloses the power semiconductor dies 120. That is, the power module 100 does not include a lid that covers the power semiconductor dies 120. The lidless electrically insulative enclosure 130 itself also laterally encloses the power semiconductor dies 120. The electrical interface 150, in this case ends of the pins 151 of the electrical interface 150, are accessible via the open cavity 140.

The lidless electrically insulative enclosure 130 may include a single piece or may be formed from multiple separate pieces. The lidless electrically insulative enclosure 130 may be attached to the substrate 110, for example an outer perimeter of the substrate 110. Metallic fasteners 170 jut out from exterior side faces of the lidless electrically insulative enclosure 130. The metallic fasteners 170 may be configured to attach the power module 100 to a component (e.g., a heatsink) of the application into which the power module 100 will be integrated.

In some examples, the lidless electrically insulative enclosure 130 is a molded enclosure that is formed from a mold compound. A mold compound is a plastic encapsulant typically formed from an organic resin such as an epoxy resin. The plastic encapsulant may include fillers such as non-melting inorganic materials. Catalysts may be used to accelerate the cure reaction of the organic resin. Other materials such as flame retardants, adhesion promoters, ion traps, stress relievers, colorants, etc. may be added to the plastic encapsulant, as appropriate. In such examples, the lidless electrically insulative enclosure 130 may be formed by injection molding, compression molding, film-assisted molding (FAM), reaction injection molding (RIM), resin transfer molding (RTM), blow molding, etc.

Although omitted from the view of FIG. 1 to better illustrate the other features of the power module 100, an electrically insulative coating is applied to at least part of the first metallized side 111 of the substrate 110, at least part of the power semiconductor dies 120, and at least part of the electrical interface 150. The electrically insulative coating will be illustrated and described in the subsequent figures.

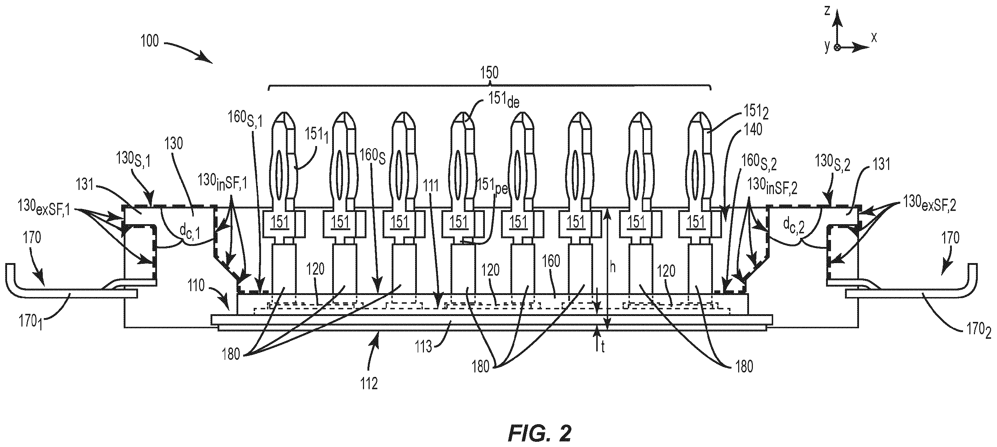

FIG. 2 illustrates a side cross-sectional view of the power module 100, according to an embodiment.

The first metallized side 111 and a second metallized side 112 of the substrate 110 are separated from one another by an electrically insulative body 113. The second metallized side 112 may include a nonpatterned metallic layer, for example to provide an interface to a heatsink of the application. The power module 100 may be 'baseplateless' in that the second metallized side 112 of the substrate 110 is designed for mounting to a heatsink (not shown in FIGS. 1 or 2) without the use of an intervening baseplate. The second metallized side 112 may include copper, aluminum, an alloy, etc. The electrically insulative body 113 may include a ceramic, polymer, composite, etc., and may include a single body or a layered (e.g., a laminate) structure. In some examples, the electrically insulative body 113 of the substrate 110 has a thickness t from about 0.25mm to about 0.635mm in the z-direction of FIG. 2. The lidless electrically insulative enclosure 130 and the substrate 110 have a combined height h in the z-direction of FIG. 2. In some examples, the combined height h of the lidless electrically insulative enclosure 130 and the substrate 110 is less than 12mm, for example 6mm or less.

A proximal end 151ₚₑ of each pin 151 of the electrical interface 150 is attached to one of the substrate 110 or a semiconductor die 120 of the plurality of semiconductor dies 120. A distal end 151_{de} of each pin 151 is accessible via the open cavity 140 of the lidless electrically insulative enclosure 130. In the example of the power module 100 of FIG. 2, each of the pins 151 is attached to the substrate 110 by a press-fit or soldered connection to a rivet 180 that is attached to the substrate 110. The rivets 180 of this example are thus part of the electrical interface 150.

As noted in the FIG. 1 description, an electrically insulative coating 160 is applied to at least part of the first metallized side 111 of the substrate 110, at least part of the power semiconductor dies 120, and at least part of the electrical interface 150. In the example of the power module 100 of FIG. 2, the electrically insulative coating 160 covers a lower part but not an upper part of each rivet 180, where the lower part of the rivets 180 adjoins the substrate 110.

In some examples, the electrically insulative coating 160 has an average thickness of 2mm or less. As noted previously, sufficiently isolating the first metallization layer 112 and the power semiconductor dies 120 with the electrically insulative coating 160 having a thickness in this range may be enabled by forming the electrically insulative coating 160 from a jetted compound using a jetting process to produce a conformal coating. A jetted compound used to form the electrically insulative coating 160 may include an insulating polymer, e.g., an epoxy resin, polyacrylate, polyurethane, polyimide, or a silicone-based gel which is liquid or viscous during the jetting process and may be subsequently hardened by curing, for example by humidity, temperature, light impact, or other external influence. A jetting process may include dispensing a liquid jetting compound over the substrate 110, the power semiconductor dies 120, and portions of the electrical interface 150. While the jetting process described hereafter references a liquid jetting compound, the process described may alternatively be completed with a viscous jetting compound. The liquid jetting compound may be dispensed continuously and/or in incremental volumes from a nozzle or other dispensing feature that is moved above and across the substrate 110, power semiconductor dies 120, and the proximal ends 151ₚₑ of the conductors 151 of the electrical interface 150. Defined volumes of the liquid jetting compound are dispensed at specific positions as the nozzle or other dispensing feature moves so that the liquid jetting compound is distributed across the features to be coated. The liquid jetting compound may then settle and further distribute over the coated features and may then be hardened during curing which is induced by external influence, e.g., by humidity, temperature, light impact, etc. The jetting process may be a manual process or may be automated using a tool that includes at least a dispensing feature (e.g., a nozzle), a means for dispensing the liquid jetting compound through the nozzle in defined increments (e.g., a pump), and a means for moving the dispensing feature to specified positions over the substrate 110, the power semiconductor dies 120, and portions of the electrical interface 150.

In some examples, the electrically insulative coating 160 includes a potting compound, for example a gel compound, epoxy compound, urethane compound, silicone compound, etc. A potting compound may simply be poured into the enclosure 130 in liquid or viscous form, and then allowed to cure into a solid or gel. In some such examples, the potting compound may have a thickness of 2mm to 3mm.

The metallic fasteners 170 of the power module 100 include a first metallic fastener 170, and a second metallic fastener 170₂ that each jut out from a first exterior side face 130_{exSF,1} of the lidless electrically insulative enclosure 130 and a second exterior side face 130_{exSF,2} of the lidless electrically insulative enclosure 130 opposite the first exterior side face 130_{exSF,1}, respectively. A creepage distance *d_{C,1}* between the first metallic fastener 170₁ and a neighboring conductor 151₁ of the electrical interface 150 includes the first exterior side face 130_{exSF,1} of the lidless electrically insulative enclosure 130, a first interior side face 130_{inSF,1} of the lidless electrically insulative enclosure 130 that opposes the first exterior side face 130_{exSF,1}, a surface 130_{S,1} of the lidless electrically insulative enclosure 130 that extends between the first exterior side face 130_{exSF,1} and the first interior side face 130_{inSF,1}, and a first portion 160_{S,1} of a surface 160s of the electrically insulative coating 160. A creepage distance *d_{c,2}* between the second metallic fastener 170₂ and a neighboring conductor 151₂ of the electrical interface 150 includes the second exterior side face 130_{exSF,2} of the lidless electrically insulative enclosure 130, a second interior side face 130_{inSF,2} of the lidless electrically insulative enclosure 130 that opposes the second exterior side face 130_{exSF,2}, a surface 130_{S,2} of the lidless electrically insulative enclosure 130 that extends between the second exterior side face 130_{exSF,2} and the second interior side face 130_{inSF,2}, and a second portion 160_{S,2} of the surface 160s of the electrically insulative coating 160.

In the example of the power module 100 of FIG. 2, the exterior side faces 130_{exSF,1} and 130_{exSF,2} of the lidless electrically insulative enclosure 130 include a protruding ridge 131 that extends along at least a part of an outer perimeter of the lidless electrically insulative enclosure 130. Including the protruding ridge 131 on the exterior side faces 130_{exSF,1} and 130_{exSF,2} as illustrated may increase the creepage distances *d_{c,1}* and *d_{c,2}*, respectively, when compared to an example of the electrically insulative enclosure 130 that does not include the protruding ridge 131.

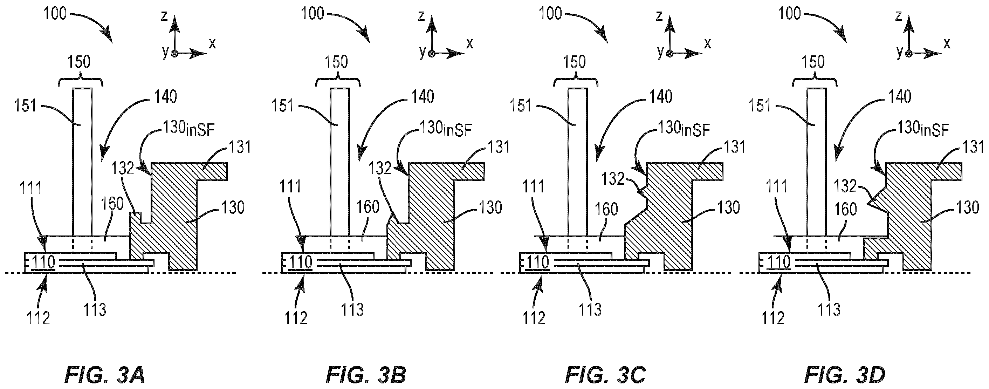

FIGS. 3A-3D illustrate partial side cross-sectional views of the power module 100, according to further embodiments. Each of FIGS. 3A-3D illustrates an example in which an interior side face 130_{inSF} of the lidless electrically insulative enclosure 130 (e.g., the interior side face 130_{inSF,1} and/or 130_{inSF,2}) includes a protruding ridge 132 that extends along at least a part of an inner perimeter of the lidless electrically insulative enclosure 130. Including the protruding ridge 132 on the interior side face 130_{inSF} as illustrated may increase the creepage distances of creepage pathways that extend along the electrically insulative enclosure, for example the creepage distances *d_{c,1}* and *d_{c,2}* of FIG. 2, when compared to an example of the electrically insulative enclosure 130 that does not include the protruding ridge 132.

FIGS. 3A and 3B illustrate examples in which the protruding ridge 132 protrudes in the z direction. FIGS. 3C and 3D illustrate examples in which the protruding ridge 132 protrudes inward in the x direction into the open cavity 140 of the lidless electrically insulative enclosure 130. Other orientations of the protruding ridge 132 are contemplated. Some examples of the power module 100 may include multiple protruding ridges 132 on one or more interior side faces 130_{inSF}. For example, an interior side face 130_{inSF} may include a combination of two or more of the protruding ridges 132 of FIG. 3A-3D and/or one or more protruding ridges 132 having a different orientation than those illustrated in FIGS. 3A-3D.

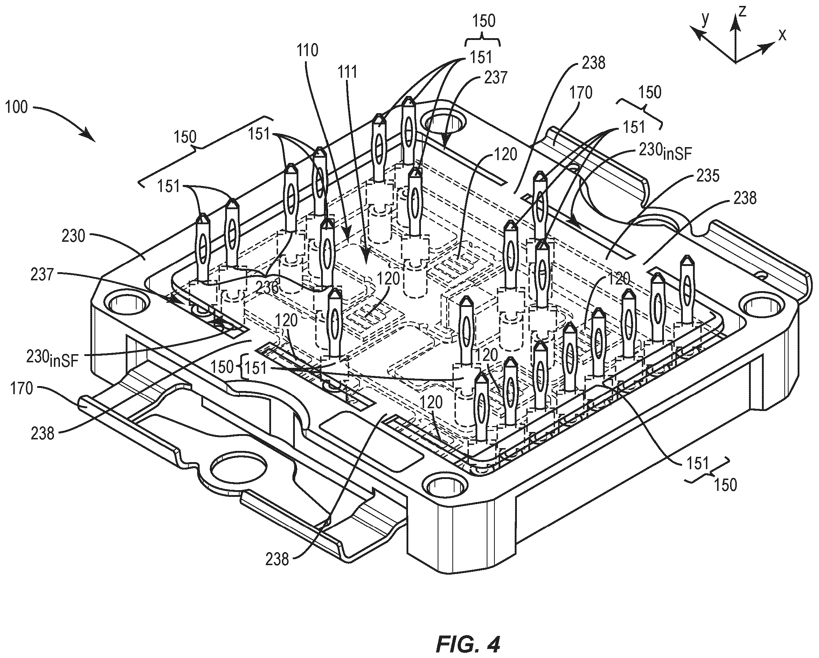

FIG. 4 illustrates a perspective view of the power module 100, according to an embodiment. The power module 100 of FIG. 4 includes an electrically insulative enclosure 230 laterally enclosing the power semiconductor dies 120. The electrically insulative enclosure 230 differs from the lidless electrically insulative enclosure 130 of FIGS. 1-3D in that the enclosure 230 in FIG. 4 includes a lid 235 that covers the power semiconductor dies 120. Each conductor 151 of the electrical interface 150, in this example, each pin 151, protrudes through an opening 236 in the lid 235. The electrically insulative enclosure 230 includes a gap 237 between the lid 235 and an interior side face 230_{inSF} of the electrically insulative enclosure 230. In some examples, the gap 237 is larger than 1mm.

The lid 235 may be formed integrally with the rest of the electrically insulative enclosure 230 (e.g., during a single molding process) or may be formed as a separate piece. In this example, the lid 235 is attached to the interior side face 230_{inSF} by a plurality of tabs 238. Other means of attaching the lid 235 to the interior side face 230_{inSF} and/or other parts of the electrically insulative enclosure 230 are contemplated. Examples in which the lid 235 is not attached to the rest of the electrically insulative enclosure 230 are contemplated (e.g., a floating lid 235 or a lid 235 supported by columns vertically interposed between the lid 235 and the substrate 110).

The electrically insulative enclosure 230 may otherwise be similar to the lidless electrically insulative enclosure 130 of FIGS. 1-3D (e.g., material composition, dimensions, structure, etc.). The power module 100 of FIG. 4 and its other features (e.g., the substrate 110, the power semiconductor dies 120, the electrical interface 150 and its pins 151, the metallic fasteners 170) may otherwise be similar to the power module 100 of FIGS. 1-3D.

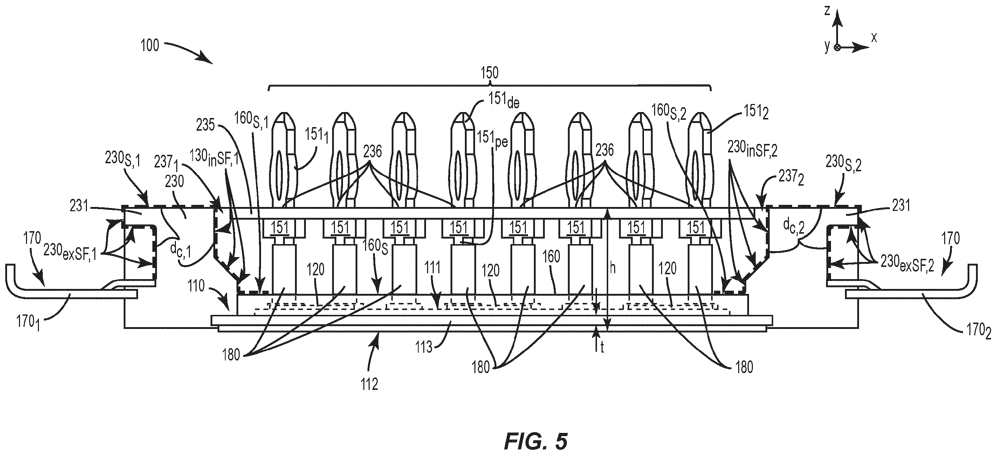

FIG. 5 illustrates a side cross-sectional view of the power module 100, according to an embodiment.

Each pin 151 of the electrical interface 150 protrudes through an opening 236 in the lid 235 of the electrically insulative enclosure 230 such that the distal end 151_{de} of each pin 151 is externally accessible from outside of the electrically insulative enclosure 230. Each of the pins 151 is attached to the substrate 110 by a press-fit or soldered connection to a rivet 180 that is attached to the substrate 110 in a similar manner to the electrical interface 150 of the power module 100 of FIG. 2, although other means of attaching the pins 151 to the substrate 110 and/or the power semiconductor dies 120 are contemplated. The rivets 180 of this example are thus part of the electrical interface 150.

The electrically insulative enclosure 230 and the substrate 110 have a combined height h in the z-direction of FIG. 5. In some examples, the combined height h of the electrically insulative enclosure 230 and the substrate 110 is less than 12mm, for example 6mm or less. The electrically insulative enclosure 230 includes a gap 237₁ between the lid 235 and a first interior side face 230_{inSF,1} of the electrically insulative enclosure 230, and a gap 237₂ between the lid 235 and a second interior side face 230_{inSF,2} of the electrically insulative enclosure 230. In some examples, one or both of the gaps 237₁ and 237₂ is larger than 1mm.

As in the examples of power module 100 of FIGS. 1-3D, an electrically insulative coating 160 is applied to at least part of the first metallized side 111 of the substrate, at least part of the power semiconductor dies 120, and at least part of the electrical interface 150. As in those examples, the electrically insulative coating 160 of the power module 100 of FIG. 5 covers a lower part but not an upper part of each rivet 180, where the lower part of the rivets 180 adjoins the substrate 110. The composition, thickness, and/or other properties of the electrically insulative coating 160 of the power module 100 of FIG. 5 may be similar to the electrically insulative coating 160 described in reference to FIG. 2. For example, the electrically insulative coating 160 illustrated in FIG. 5 may have an average thickness of 2mm or less, may include a jetted compound deposited using a jetting process, may include a potting compound (e.g., a gel compound, epoxy compound, urethane compound, silicone compound), etc.

A first metallic fastener 170₁ and a second metallic fastener 170₂ jut out from a first exterior side face 230_{exSF,1} and second exterior side face 230_{exSF,2} opposite the first exterior side face 230_{exSF,1} of the electrically insulative enclosure 230, respectively. A creepage distance *d_{c,1}* between the first metallic fastener 170₁ and a neighboring conductor 151₁ of the electrical interface 150 includes the first exterior side face 230_{exSF,1} of the electrically insulative enclosure 230, the first interior side face 230_{inSF,1} of the electrically insulative enclosure 230 that opposes the first exterior side face 230_{exSF,1}, and a surface 230_{S,1} of the electrically insulative enclosure 230 that extends between the first exterior side face 230_{exSF,1} and the first interior side face 230_{inSF,1}. A creepage distance *d*_{*C*,*2*} between the second metallic fastener 170₂ and a neighboring conductor 151₂ of the electrical interface 150 includes the second exterior side face 230_{exSF,2} of the electrically insulative enclosure 230, the second interior side face 230_{inSF,2} of the electrically insulative enclosure 230 that opposes the second exterior side face 230_{exSF,2}, and a surface 230_{S,2} of the electrically insulative enclosure 230 that extends between the second exterior side face 230_{exSF,2} and the second interior side face 230_{inSF,2}. In this example, the creepage distances *d_{c,1}* and *d_{c,2}* each include a portion 160_{S,1} and 160_{S,2}, respectively of a surface 160s of the electrically insulative coating 160.

In the example of the power module 100 of FIG. 2, the exterior side faces 230_{exSF,1} and 230_{exSF,2} of the electrically insulative enclosure 230 include a protruding ridge 231 that extends along at least a part of an outer perimeter of the electrically insulative enclosure 230. Including the protruding ridge 231 on the exterior side faces 230_{exSF,1} and 230_{exSF,2} as illustrated may increase the creepage distances *d_{c,1}* and *d_{c,2}*, respectively, when compared to an example of the electrically insulative enclosure 230 that does not include the protruding ridge 231.

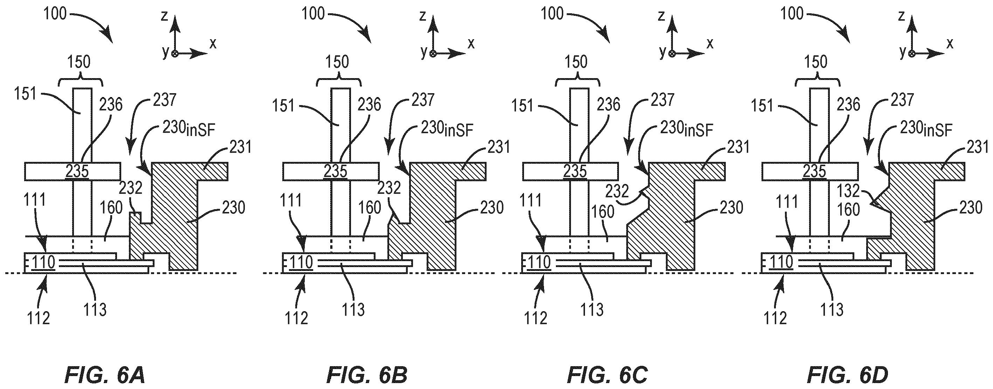

FIGS. 6A-6D illustrate partial side cross-sectional views of a power module, according to embodiments.

FIGS. 6A-6D illustrate partial side cross-sectional views of the power module 100, according to further embodiments. Each of FIGS. 6A-6D illustrates an example in which an interior side face 230_{inSF} of the electrically insulative enclosure 230 (e.g., interior side face 230_{inSF,1} and/or 230_{inSF,2}) includes a protruding ridge 232 that extends along at least a part of an inner perimeter of the electrically insulative enclosure 230. Including the protruding ridge 232 on the interior side face 230_{inSF} as illustrated may increase the creepage distances of creepage pathways that extend along the electrically insulative enclosure, for example the creepage distances *d_{c,1}* and *d_{c,2}* of FIG. 5, when compared to an example of the electrically insulative enclosure 230 that does not include the protruding ridge 232.

FIGS. 6A and 6B illustrate examples in which the protruding ridge 232 protrudes in the z direction toward the gap 237 between the lid 235 and the interior side face 230_{inSF}. FIGS. 3C and 3D illustrate examples in which the protruding ridge 232 protrudes inward in the x direction toward the lid 235. Other orientations of the protruding ridge 232 are contemplated. Some examples of the power module 100 may include multiple protruding ridges 232 on one or more interior side faces 230_{inSF}. For example, an interior side face 230_{inSF} may include a combination of two or more of the protruding ridges 232 of FIG. 6A-6D and/or one or more protruding ridges 632 having a different orientation than those illustrated in FIGS. 6A-6D.

Although the present disclosure is not so limited, the following numbered examples demonstrate one or more aspects of the disclosure.

Example 1. A power module, comprising: a substrate comprising a first metallized side and a second metallized side separated from one another by an electrically insulative body; a plurality of power semiconductor dies attached to the first metallized side of the substrate; a lidless electrically insulative enclosure, the lidless electrically insulative enclosure and the substrate defining an open cavity which laterally encloses the power semiconductor dies; an electrical interface for the power semiconductor dies that is accessible via the open cavity; and an electrically insulative coating applied to at least part of the first metallized side of the substrate, at least part of the power semiconductor dies, and at least part of the electrical interface, wherein a combined height of the lidless electrically insulative enclosure and the substrate is 6mm or less.

Example 2. The power module of example 1, further comprising: a first metallic fastener jutting out from a first exterior side face of the lidless electrically insulative enclosure, wherein a creepage distance between the first metallic fastener and a neighboring conductor of the electrical interface includes the first exterior side face of the lidless electrically insulative enclosure, a first interior side face of the lidless electrically insulative enclosure that opposes the first exterior side face, a surface of the lidless electrically insulative enclosure that extends between the first exterior side face and the first interior side face, and a first portion of a surface of the electrically insulative coating.

Example 3. The power module of example 2, further comprising: a second metallic fastener jutting out from a second exterior side face of the lidless electrically insulative enclosure opposite the first exterior side face, wherein a creepage distance between the second metallic fastener and a neighboring conductor of the electrical interface includes the second exterior side face of the lidless electrically insulative enclosure, a second interior side face of the lidless electrically insulative enclosure that opposes the second exterior side face, a surface of the lidless electrically insulative enclosure that extends between the second exterior side face and the second interior side face, and a second portion of the surface of the electrically insulative coating.

Example 4. The power module of any of examples 1 through 3, wherein the electrically insulative coating has an average thickness of 2mm or less.

Example 5. The power module of any of examples 1 through 4, wherein the electrically insulative coating comprises a jetted compound comprising an insulating polymer.

Example 6. The power module of any of examples 1 through 3, wherein the electrically insulative coating comprises a potting compound having a thickness of 2mm to 3mm.

Example 7. The power module of any of examples 1 through 6, wherein the electrical interface comprises a plurality of conductors each comprising a pin, and wherein a proximal end of each pin is attached to one of the substrate or a semiconductor die of the plurality of semiconductor dies, and a distal end of each pin is accessible via the open cavity of the lidless electrically insulative enclosure.

Example 8. The power module of example 7, wherein one or more of the pins is attached to the substrate by a press-fit or soldered connection to a rivet that is attached to the substrate, and wherein the electrically insulative coating covers a lower part but not an upper part of each rivet.

Example 9. The power module of any of examples 1 through 8, wherein an exterior side face of the lidless electrically insulative enclosure comprises a protruding ridge that extends along at least a part of an outer perimeter of the lidless electrically insulative enclosure.

Example 10. The power module of any of examples 1 through 9, wherein an interior side face of the lidless electrically insulative enclosure comprises a protruding ridge that extends along at least a part of an inner perimeter of the lidless electrically insulative enclosure.

Example 11. A power module, comprising: a substrate comprising a first metallized side and a second metallized side separated from one another by an electrically insulative body; a plurality of power semiconductor dies attached to the first metallized side of the substrate; an electrically insulative enclosure laterally enclosing the power semiconductor dies; an electrical interface for the power semiconductor dies; and a first metallic fastener jutting out from a first exterior side face of the electrically insulative enclosure, wherein a creepage distance between the first metallic fastener and a neighboring conductor of the electrical interface includes the first exterior side face of the electrically insulative enclosure, a first interior side face of the electrically insulative enclosure that opposes the first exterior side face, and a surface of the electrically insulative enclosure that extends between the first exterior side face and the first interior side face, wherein a combined height of the electrically insulative enclosure and the substrate is 6mm or less.

Example 12. The power module of example 11, wherein the electrically insulative enclosure includes a lid covering the power semiconductor dies, wherein each conductor of the electrical interface protrudes through an opening in the lid, and wherein a gap between the lid and the first interior side face of the electrically insulative enclosure is larger than 1mm.

Example 13. The power module of example 11, further comprising: a second metallic fastener jutting out from a second exterior side face of the electrically insulative enclosure opposite the first exterior side face, wherein a creepage distance between the second metallic fastener and a neighboring conductor of the electrical interface includes the second exterior side face of the electrically insulative enclosure, a second interior side face of the electrically insulative enclosure that opposes the second exterior side face, and a surface of the electrically insulative enclosure that extends between the second exterior side face and the second interior side face.

Example 14. The power module of example 13, wherein the electrically insulative enclosure includes a lid covering the power semiconductor dies, wherein each conductor of the electrical interface protrudes through an opening in the lid, wherein a gap between the lid and the first interior side face of the electrically insulative enclosure is larger than 1mm, and wherein a gap between the lid and the second interior side face of the electrically insulative enclosure is larger than 1mm.

Example 15. The power module of any of examples 11 through 14, further comprising an electrically insulative coating applied to at least part of the first metallized side of the substrate, at least part of the power semiconductor dies, and at least part of the electrical interface, the electrically insulative coating having an average thickness of 2mm or less.

Example 16. The power module of example 15, wherein the creepage distance between the first metallic fastener and a nearest conductor of the electrical interface includes a portion of a surface of the electrically insulative coating.

Example 17. The power module of example 15 or 16, wherein the electrically insulative coating comprises a jetted compound comprising an insulating polymer.

Example 18. The power module of any of examples 11 through 17, wherein the electrical interface comprises a plurality of conductors each comprising a pin, and wherein each pin is attached to one of the substrate or a semiconductor die.

Example 19. The power module of example 18, wherein one or more of the pins is attached to the substrate by a press-fit or soldered connection to a rivet that is attached to the substrate, and wherein the electrically insulative coating covers a lower part but not an upper part of each rivet.

Example 20. The power module of any of examples 11 through 19, wherein an exterior side face of the electrically insulative enclosure comprises a protruding ridge that extends along at least a part of an outer perimeter of the electrically insulative enclosure.

Example 21. The power module of any of examples 11 through 20, wherein an interior side face of the electrically insulative enclosure comprises a protruding ridge that extends along at least a part of an inner perimeter of the electrically insulative enclosure.

Terms such as "first", "second", and the like, are used to describe various elements, regions, sections, etc. and are also not intended to be limiting. Like terms refer to like elements throughout the description.

As used herein, the terms "having", "containing", "including", "comprising" and the like are open ended terms that indicate the presence of stated elements or features, but do not preclude additional elements or features. The articles "a", "an" and "the" are intended to include the plural as well as the singular, unless the context clearly indicates otherwise.

The expression "and/or" should be interpreted to include all possible conjunctive and disjunctive combinations, unless expressly noted otherwise. For example, the expression "A and/or B" should be interpreted to mean only A, only B, or both A and B. The expression "at least one of" should be interpreted in the same manner as "and/or", unless expressly noted otherwise. For example, the expression "at least one of A and B" should be interpreted to mean only A, only B, or both A and B.

It is to be understood that the features of the various embodiments described herein can be combined with each other, unless specifically noted otherwise.

Although specific embodiments have been illustrated and described herein, it will be appreciated by those of ordinary skill in the art that a variety of alternate and/or equivalent implementations can be substituted for the specific embodiments shown and described without departing from the scope of the present invention. This application is intended to cover any adaptations or variations of the specific embodiments discussed herein. Therefore, it is intended that this invention be limited only by the claims and the equivalents thereof.

## Claims

1. A power module (100), comprising:
a substrate (110) comprising a first metallized side (111) and a second metallized side (112) separated from one another by an electrically insulative body (113);
a plurality of power semiconductor dies (120) attached to the first metallized side (111) of the substrate (110);
a lidless electrically insulative enclosure (130), the lidless electrically insulative enclosure (130) and the substrate (110) defining an open cavity (140) which laterally encloses the power semiconductor dies (120);
an electrical interface (150) for the power semiconductor dies (120) that is accessible via the open cavity (140); and
an electrically insulative coating (160) applied to at least part of the first metallized side (111) of the substrate (110), at least part of the power semiconductor dies (120), and at least part of the electrical interface (150),
wherein a combined height of the lidless electrically insulative enclosure (130) and the substrate (110) is 6mm or less.

2. The power module (100) of claim 1, further comprising:
a first metallic fastener (170₁) jutting out from a first exterior side face (230_{exSF,1}) of the lidless electrically insulative enclosure (130),
wherein a creepage distance (*d_{C,1}*) between the first metallic fastener (170₁) and a neighboring conductor (151₁) of the electrical interface (150) includes the first exterior side face (230_{exSF,1}) of the lidless electrically insulative enclosure (130), a first interior side face (130_{inSF,1}) of the lidless electrically insulative enclosure (130) that opposes the first exterior side face (230_{exSF,1}), a surface of the lidless electrically insulative enclosure (130) that extends between the first exterior side face (230_{exSF,1}) and the first interior side face (130_{inSF,1}), and a first portion of a surface of the electrically insulative coating (160).

3. The power module (100) of claim 2, further comprising:
a second metallic fastener (170₂) jutting out from a second exterior side face (230_{exSF,2}) of the lidless electrically insulative enclosure (130) opposite the first exterior side face (230_{exSF,1}),
wherein a creepage distance (*d_{c,2}*) between the second metallic fastener (170₂) and a neighboring conductor (151₂) of the electrical interface (150) includes the second exterior side face (230_{exSF,2}) of the lidless electrically insulative enclosure (130), a second interior side face (130_{inSF,2}) of the lidless electrically insulative enclosure (130) that opposes the second exterior side face (230_{exSF,2}), a surface of the lidless electrically insulative enclosure (130) that extends between the second exterior side face (230_{exSF,2}) and the second interior side face (130_{inSF,2}), and a second portion of the surface of the electrically insulative coating (160).

4. The power module (100) of claim 1, wherein at least one of
the electrically insulative coating (160) has an average thickness of 2mm or less,
the electrically insulative coating (160) comprises a jetted compound comprising an insulating polymer, and
the electrically insulative coating (160) comprises a potting compound having a thickness of 2mm to 3mm.

5. The power module (100) of claim 1,
wherein the electrical interface (150) comprises a plurality of conductors (151) each comprising a pin, and
wherein a proximal end (151ₚₑ) of each pin is attached to one of the substrate (110) or a semiconductor die (120) of the plurality of semiconductor dies (120), and a distal end (151_{de}) of each pin is accessible via the open cavity (140) of the lidless electrically insulative enclosure (130).

6. The power module (100) of claim 5, wherein one or more of the pins is attached to the substrate (110) by a press-fit or soldered connection to a rivet (180) that is attached to the substrate (110), and wherein the electrically insulative coating (160) covers a lower part but not an upper part of each rivet (180).

7. The power module (100) of claim 1, wherein at least one of
an exterior side face (230_{exSF,1}, 230_{exSF,2}) of the lidless electrically insulative enclosure (130) comprises a protruding ridge (131) that extends along at least a part of an outer perimeter of the lidless electrically insulative enclosure (130), and
an interior side face (130_{inSF,1}, 130_{inSF,2}) of the lidless electrically insulative enclosure (130) comprises a protruding ridge (132) that extends along at least a part of an inner perimeter of the lidless electrically insulative enclosure (130).

8. A power module (100), comprising:
a substrate (110) comprising a first metallized side (111) and a second metallized side (112) separated from one another by an electrically insulative body (113);
a plurality of power semiconductor dies (120) attached to the first metallized side (111) of the substrate (110);
an electrically insulative enclosure (230) laterally enclosing the power semiconductor dies (120);
an electrical interface (150) for the power semiconductor dies (120); and
a first metallic fastener (170₁) jutting out from a first exterior side face (230_{exSF,1}) of the electrically insulative enclosure (230),
wherein a creepage distance (*d_{C,1}*) between the first metallic fastener (170₁) and a neighboring conductor (151₁) of the electrical interface (150) includes the first exterior side face (230_{exSF,1}) of the electrically insulative enclosure (230), a first interior side face (130_{inSF,1}) of the electrically insulative enclosure (230) that opposes the first exterior side face (230_{exSF,1}), and a surface of the electrically insulative enclosure (230) that extends between the first exterior side face (230_{exSF,1}) and the first interior side face (130_{inSF,1}),
wherein a combined height of the electrically insulative enclosure (230) and the substrate (110) is 6mm or less.

9. The power module (100) of claim 8, wherein the electrically insulative enclosure (230) includes a lid (235) covering the power semiconductor dies (120), wherein each conductor of the electrical interface (150) protrudes through an opening (236) in the lid (235), and wherein a gap (237) between the lid (235) and the first interior side face (130_{inSF,1}) of the electrically insulative enclosure (230) is larger than 1mm.

10. The power module (100) of claim 8, further comprising:
a second metallic fastener (170₂) jutting out from a second exterior side face (230_{exSF,2}) of the electrically insulative enclosure (230) opposite the first exterior side face (230_{exSF,1}),
wherein a creepage distance (*d_{c,2}*) between the second metallic fastener (170₂) and a neighboring conductor (151₂) of the electrical interface (150) includes the second exterior side face (230_{exSF,2}) of the electrically insulative enclosure (230), a second interior side face (130_{inSF,2}) of the electrically insulative enclosure (230) that opposes the second exterior side face (230_{exSF,2}), and a surface of the electrically insulative enclosure (230) that extends between the second exterior side face (230_{exSF,2}) and the second interior side face (130_{inSF,2}).

11. The power module (100) of claim 10, wherein the electrically insulative enclosure (230) includes a lid (235) covering the power semiconductor dies (120), wherein each conductor of the electrical interface (150) protrudes through an opening (236) in the lid (235), wherein a gap (237) between the lid (235) and the first interior side face (130_{inSF,1}) of the electrically insulative enclosure (230) is larger than 1mm, and wherein a gap (237) between the lid (235) and the second interior side face (130_{inSF,2}) of the electrically insulative enclosure (230) is larger than 1mm.

12. The power module (100) of claim 8, further comprising an electrically insulative coating (160) applied to at least part of the first metallized side (111) of the substrate (110), at least part of the power semiconductor dies (120), and at least part of the electrical interface (150), the electrically insulative coating (160) having an average thickness of 2mm or less.

13. The power module (100) of claim 12, wherein the creepage distance (*d_{C,1}*) between the first metallic fastener (170₁) and a nearest conductor of the electrical interface (150) includes a portion of a surface of the electrically insulative coating (160).

14. The power module (100) of claim 12, wherein the electrically insulative coating (160) comprises a jetted compound comprising an insulating polymer.

15. The power module (100) of claim 8,
wherein the electrical interface (150) comprises a plurality of conductors (151) each comprising a pin, and
wherein each pin is attached to one of the substrate (110) or a semiconductor die.
